# EUROPEAN PATENT APPLICATION

(11) **EP 3 608 974 A1**
(43) Date of publication of application: **12.02.2020**
(21) Application number: 17903530.8
(22) Date of filing: 10.08.2017
(51) Int. Cl.: H01L 31/0224, H01L 31/18

(54) **CELL STRING FORMED BY CONNECTING N-TYPE IBC SOLAR CELLS IN SPLICED-SHEET MANNER, PREPARATION METHOD THEREFOR, ASSEMBLY AND SYSTEM**

(30) Priority: 01.04.2017 CN 201710213160
(71) Applicant: Jolywood (Taizhou) Solar Technology Co., Ltd., Taizhou, Jiangsu 225500 (CN)
(72) Inventor: LIN, Jianwei, Taizhou Jiangsu 225500 (CN); LIU, Zhifeng, Taizhou Jiangsu 225500 (CN); ZHANG, Kangping, Taizhou Jiangsu 225500 (CN); JI, Genhua, Taizhou Jiangsu 225500 (CN); LIU, Yong, Taizhou Jiangsu 225500 (CN)
(74) Representative: Plasseraud IP
(86) International application number: PCT/CN2017/000516
(87) International publication number: WO 2018/176182

(57) **Abstract**

The present application relates to a cell string formed by spliced N-type IBC solar cells and a preparation method thereof, a solar cell module, and a solar cell system. The cell string comprises narrow N-type IBC solar cells and a conducting member configured to realize Ohmic connection between the narrow N-type IBC solar cells, with emitter p+ regions and base n+ regions being alternately arranged on a back surface of each of the narrow N-type IBC solar cells, p+ emitter contact electrodes being arranged in the emitter p+ regions, n+ base contact electrodes being arranged in the base n+ regions, further comprising p+ electrode current convergence points arranged on the p+ emitter contact electrodes and n+ electrode current convergence points arranged on the n+ base contact electrodes, with an insulating barrier layer being arranged around the current convergence points, and the conducting member being arranged between the adjacent narrow N-type IBC cells. The present application has the following beneficial effect. In the present application, a cell string formed by spliced N-type IBC solar cells is realized by the use of an insulating barrier layer and a conducting member. Since the gap between the cells may be controlled to be less than 0.2 mm, the power of the solar cell module will be far higher when compared with the conventional connection methods for cell strings. In addition, the manufacturing process of the solar cell module is simple and less costly.

## Description

### TECHNICAL FIELD

The present application relates to the technical field of solar cells and in particular to a cell string formed by spliced N-type IBC solar cells and a preparation method thereof, a solar cell module, and a solar cell system.

### BACKGROUND

Solar cells are semiconductor devices that convert light energy into electrical energy. Low production cost and high energy conversion efficiency have always been the goal pursued in the solar cell industry. For a conventional solar cell, the emitter contact electrodes and the base contact electrodes are respectively located on front and back sides of the cell. The front side of the cell is a light receiving surface, and the coverage of the metal emitter contact electrodes on the front side will cause part of incident sunlight to be reflected by the metal electrodes, causing certain optical loss. For a common crystalline silicon solar cell, the coverage area of the metal electrodes on the front side is about 7%. Reducing the coverage of the metal electrodes on the front side can directly improve the energy conversion efficiency of the cell. A N-type IBC solar cell is a cell in which both the emitter contact electrodes and the base contact electrodes are placed on the back surface (not the light-receiving surface) of the cell, with the light-receiving surface of the cell not shielded by any metal electrode. Thus, the short-circuit current of the cell is effectively increased, and the energy conversion efficiency of the cell is improved.

Solar cells with an N-type IBC structure are cells with highest energy conversion efficiency, among the crystalline silicon solar cells produced by solar cell industrialization. They have been favored due to their high conversion efficiency and low component packaging cost. In the conventional N-type IBC solar cell fabrication process, the metallization process is mostly realized by electroplating which is complicated. This method works well in reducing the series resistance of the N-type IBC cells and increasing the open-circuit voltage of the cells. However, the method has complicated processes, the discharged waste may seriously pollute the environment, and it is not compatible with most of metallization methods in the current industrial production. Therefore, it is not conducive to low-cost industrialization. Meanwhile, in the process of packaging N-type IBC cells into a module, it is very difficult to realize alignment and welding between adjacent cells due to a large number of emitter and base electrodes and the small line width. On the other hand, in the process of packaging cells into a module, the power loss is mostly caused by the welding resistance and the ribbon resistance. The higher the short-circuit current of a single cell, the greater the power loss.

### SUMMARY

In view of the insufficiency above, an objective of the present application is to provide a cell string formed by spliced N-type IBC solar cells. The technical solutions will be described below.

A cell string formed by spliced N-type IBC solar cells is provided, comprising narrow N-type IBC solar cells and a conducting member configured to realize Ohmic connection between the narrow N-type IBC solar cells, with emitter p+ regions and base n+ regions being alternately arranged on a back surface of each of the narrow N-type IBC solar cells, p+ emitter contact electrodes being arranged in the emitter p+ regions, n+ base contact electrodes being arranged in the base n+ regions, further comprising p+ electrode current convergence points arranged on the p+ emitter contact electrodes and n+ electrode current convergence points arranged on the n+ base contact electrodes, with an insulating barrier layer being arranged around the p+ electrode current convergence points and the n+ electrode current convergence points, and the conducting member being arranged between the adjacent narrow N-type IBC cells.

The cell string formed by spliced N-type IBC solar cells of the present application may further include the following dependent technical solutions.

Wherein, the narrow N-type IBC solar cell comprises an N-type monocrystalline silicon substrate; the N-type monocrystalline silicon substrate has, on its front surface, a n+ doped front surface field and a front surface passivation and anti-inflection film successively from inside out; the N-type monocrystalline silicon substrate has, on its back surface, back surface p+ regions and back surface n+ regions that are alternately arranged successively from inside out, back surface passivation films, and back surface electrodes; and the back surface electrodes comprise p+ emitter contact electrodes and n+ base contact electrodes.

Wherein, the silicon substrate of the narrow N-type IBC solar cell has a resistivity of 1-30 Ω•cm and a thickness of 100-200 µm; the emitter p+ regions and the base n+ regions, which are in a strip shape, are alternately arranged on the back surface of the substrate of the solar cell.

Wherein, the emitter p+ regions have a width of 500-1500 µm and the base n+ regions have a width of 200-500 µm.

Wherein, both the p+ emitter contact electrodes and the n+ base contact electrodes have a width of 50-150 µm.

Wherein, the p+ electrode current convergence points and the n+ electrode current convergence points are sequentially arranged on the cell in a strip shape; and both the p+ electrode current convergence points and the n+ electrode current convergence points are round points with a diameter of 500 µm, square points with a length of 500 µm on each side, or metal points in other shapes with an equivalent area.

Wherein, both the p+ emitter contact electrodes and the n+ base contact electrodes are silver fine grid line electrodes, and both the p+ electrode current convergence points and the n+ electrode current convergence points are silver points.

Wherein, the insulating barrier layer is elongated and has a width of 5 -10 mm and a length of 156 mm; and the insulating barrier layer is covered on arrays of the p+ electrode current convergence points and the n+ electrode current convergence points, respectively, with the p+ electrode current convergence points and the n+ electrode current convergence points exposed from the insulating barrier layer.

The present application further provides a method for preparing a cell string formed by spliced N-type IBC solar cells, comprising following steps:
(1) forming, on a back surface of a substrate of a solar cell, emitter p+ regions and base n+ regions that are alternately arranged, preparing p+ emitter contact electrodes in Ohmic contact with the emitter p+ regions and n+ base contact electrodes in Ohmic contact with the base n+ regions, and preparing p+ electrode current convergence points on the p+ emitter contact electrodes and n+ electrode current convergence points on the n+ base contact electrodes;
(2) printing insulating paste onto strips of the p+ electrode current convergence points and the n+ electrode current convergence points by screen printing, with the p+ electrode current convergence points and the n+ electrode current convergence points exposed from the insulating paste, and drying to form an insulating barrier layer;
(3) cutting, along the center of the insulating barrier layer, the substrate of the N-type IBC solar cell into a plurality of narrow N-type IBC cells, wherein the strip of the p+ electrode current convergence points and the strip of the n+ electrode current convergence points are respectively located on the outermost two sides of a long side of the narrow N-type IBC cell, and the cutting is implemented by laser cutting; and
(4) arranging the narrow N-type IBC cells by a certain rule so that the array of the p+ electrode current convergence points of one narrow N-type IBC cell and the array of the n+ electrode current convergence points of the other narrow N-type IBC cell are located between two adjacent narrow N-type IBC cells, coating conducting adhesive onto the p+ electrode current convergence points and the n+ electrode current convergence points, laying a conducting member at a joint of the narrow N-type IBC cells so that the p+ electrode current convergence points and the n+ electrode current convergence points of the adjacent narrow N-type IBC cells are electrically connected by the conducting member, and repeating this step to form a cell string formed by spliced N-type IBC solar cells.

The method for preparing the cell string formed by spliced N-type IBC solar cells of the present application may further include the following dependent technical solutions.

Wherein, in the step (1), both the p+ electrode current convergence points and the n+ electrode current convergence points are arranged in an array, with 10 to 20 p+ electrode current convergence points or n+ electrode current convergence points in each column, which are uniformly distributed.

Wherein,
in the step (4), the conducting member has a width of 4-8 mm and a thickness of 0.1-0.5 mm, and is made of a tinned copper tape.

The present application further provides a solar cell module, comprising a solar cell string, wherein the solar cell string is the cell string formed by spliced N-type IBC solar cells described above.

The present application further provides a solar cell system, comprising more than one solar cell module, wherein the solar cell module is the solar cell module described above.

The embodiments of the present application have the following technical effects.

In the present application, by splicing the cut N-type IBC cells together, the gap between the cells is greatly reduced and the number of cells that can be placed in a unit area is thus increased, so the power of a module manufactured from the cell string is increased. Moreover, the cell string is formed by spliced N-type IBC solar cells by the use of an insulating barrier layer and a conducting member, wherein the use of the insulating barrier layer greatly decreases the requirements on the alignment precision of the device, so that no welding operation is required in the manufacturing of the module and the operation is thus simple. Meanwhile, the conducting member further plays a role of transverse current convergence, so that the transverse transport loss of carriers between electrodes is reduced, and the fill factor of the cell is increased. Since the narrow cells, which are not integrated in a whole, are connected serially, the short-circuit current of the module is reduced to thus significantly reduce the packaging loss of the module.

### BRIEF DESCRIPTION OF THE DRAWINGS

Fig. 1 is a structure diagram of the back surface of an N-type IBC solar cell according to an embodiment of the present application;
Fig. 2 is a structure diagram of the back surface of the N-type IBC solar cell on which an insulating barrier layer is printed, according to an embodiment of the present application;
Fig. 3 is a schematic view of cutting of the N-type IBC solar cell into narrow N-type IBC solar cells, according to an embodiment of the present application;
Fig. 4 is a schematic view after arranging the narrow N-type IBC solar cells by a certain rule and coating conducting adhesive onto the current convergence points, according to an embodiment of the present application; and
Fig. 5 is a schematic view of the narrow N-type IBC solar cells that are serially connected by the conducting member, in the method for preparing an N-type IBC solar cell string, according to an embodiment of the present application.

### DETAILED DESCRIPTION

The present application will be described below in detail with reference to the accompanying drawings by embodiments. It is to be noted that the embodiments to be described are merely provided for understanding of the present application and not intended to limit the present application.

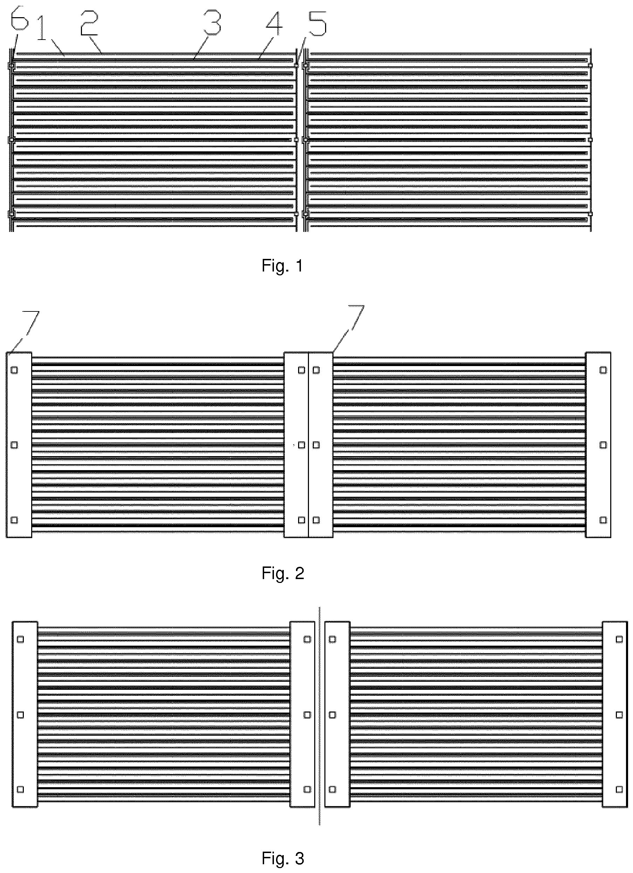

Referring to Figs. 1-5, a cell string formed by spliced N-type IBC solar cells in an embodiment comprises narrow N-type IBC solar cells and a conducting member configured to realize Ohmic connection between the narrow N-type IBC solar cells. Emitter p+ regions 1 and base n+ regions 3 are alternately arranged on a back surface of each of the narrow N-type IBC solar cells. p+ emitter contact electrodes 2 are arranged in the emitter p+ regions 1. n+ base contact electrodes 4 are arranged in the base n+ regions 3. It further comprises p+ electrode current convergence points 5 arranged on the p+ emitter contact electrodes 2 and n+ electrode current convergence points 6 arranged on the n+ base contact electrodes 4. The p+ electrode current convergence points 5 and the n+ electrode current convergence points 6 are configured to collect current and transmit it to an external circuit. An insulating barrier layer is arranged around the p+ electrode current convergence points and the n+ electrode current convergence points, and the conducting member is arranged between the adjacent narrow N-type IBC cells.

Wherein, the narrow N-type IBC solar cell comprises an N-type monocrystalline silicon substrate; the N-type monocrystalline silicon substrate has, on its front surface, a n+ doped front surface field and a front surface passivation and anti-inflection film successively from inside out; the N-type monocrystalline silicon substrate has, on its back surface, back surface p+ regions 1 and back surface n+ regions 3 that are alternately arranged successively from inside out, back surface passivation films, and back surface electrodes; and the back surface electrodes comprise p+ emitter contact electrodes 2 and n+ base contact electrodes 4.

Preferably, the silicon substrate of the narrow N-type IBC solar cell has a resistivity of 1-30 Ω•cm and a thickness of 100-200 µm; the emitter p+ regions 1 and the base n+ regions 3, which are in a strip shape, are alternately arranged on the back surface of the substrate of the solar cell. The emitter p+ regions 1 have a width of 500-1500 µm and the base n+ regions 3 have a width of 200-500 µm.

Preferably, on the back surface of the N-type IBC solar cell, the p+ emitter contact electrodes 2 have a width of 50-150 µm and the n+ base contact electrodes have a width of 50-150 µm. p+ electrode current convergence points 5 are arranged on the p+ emitter contact electrodes 2 and n+ electrode current convergence points 6 are arranged on the n+ base contact electrodes 4. The p+ electrode current convergence points 5 and the n+ electrode current convergence points 6 are sequentially arranged on the cell in a strip shape. Both the p+ electrode current convergence points 5 and the n+ electrode current convergence points 6 are round points with a diameter of 500 µm, or square points with a length of 500 µm on each side, or metal points in other shapes with an equivalent area. All the electrodes for the p+ emitter contact electrodes 2, the p+ electrode current convergence points 5, the n+ base contact electrodes 4 and the n+ electrode current convergence points 6 are made of silver.

Preferably, referring to Fig. 2, the insulating barrier layer 7 is elongated and has a width of 5 -10 mm and a length of 156 mm. The insulating barrier layer 7 is covered on arrays of the p+ electrode current convergence points 5 and the n+ electrode current convergence points 6, respectively, with the p+ electrode current convergence points 5 and the n+ electrode current convergence points 6 exposed from the insulating barrier layer.

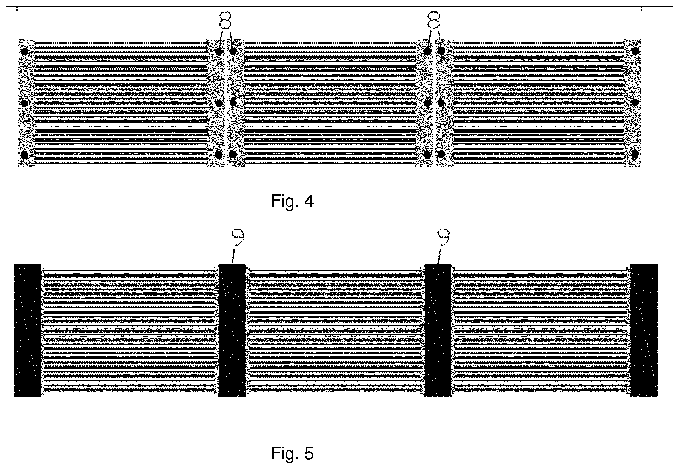

The method for preparing a cell string formed by spliced N-type IBC solar cells of the present application comprises following steps:
(1) as shown in Fig. 1, emitter p+ regions 1 and base n+ regions 3 that are alternately arranged are formed on a back surface of a substrate of a solar cel, p+ emitter contact electrodes 2 in Ohmic contact with the emitter p+ regions 1 and n+ base contact electrodes 4 in Ohmic contact with the base n+ regions 3 are prepared, and p+ electrode current convergence points 5 are prepared on the p+ emitter contact electrodes 3 and n+ electrode current convergence points 6 are prepared on the n+ base contact electrodes 4;
(2) as shown in Fig. 2, insulating paste is printed onto strips of the p+ electrode current convergence points 5 and the n+ electrode current convergence points 6 by screen printing, with the p+ electrode current convergence points 5 and the n+ electrode current convergence points 6 exposed from the insulating paste, and dried to form an insulating barrier layer 7;
(3) as shown in Fig. 3, the substrate of the N-type IBC solar cell is cut, along the center of the insulating barrier layer, into a plurality of narrow N-type IBC cells, wherein the strip of the p+ electrode current convergence points and the strip of the n+ electrode current convergence points are respectively located on the outermost two sides of a long side of the narrow N-type IBC cell, and the cutting is implemented preferably by laser cutting; and
(4) as shown in Figs. 4-5, the narrow N-type IBC cells are arranged by a certain rule so that the array of the p+ electrode current convergence points 5 of one cell and the array of the n+ electrode current convergence points 6 of the other cell are located between two adjacent narrow cells, conducting adhesive 8 is coated onto the p+ electrode current convergence points 5 and the n+ electrode current convergence points 6, a conducting member 9 with a width of 4-8 mm and a thickness of 0.1-0.5 mm and being made of a tinned copper tape is laid at a joint of the adjacent cells, so that the p+ electrode current convergence points 5 and the n+ electrode current convergence points 6 of the adjacent narrow N-type IBC cells are in Ohmic connection by the conducting member 9, and this step is repeated to form a cell string formed by spliced N-type IBC solar cells.

Preferably, in the step (1), both the p+ electrode current convergence points 5 and the n+ electrode current convergence points 6 are arranged in an array, with 20 p+ electrode current convergence points 5 or n+ electrode current convergence points 6 in each column, which are uniformly distributed.

Preferably, in the step (4), the conducting member 9 has a width of 4-8 mm and a thickness of 0.1-0.5 mm, and is made of a tinned copper tape.

This embodiment further provides a solar cell module, comprising a solar cell string, wherein the solar cell string is the N-type IBC solar cell string.

This embodiment further provides a solar cell system, comprising more than one solar cell module, wherein the solar cell module is the solar cell module described above.

At last, it should be noted that the embodiments described above are merely provided to explain the technical solution of the present application, not to confine the protection scope of the present application. Although the present application has been explained in detail by preferred embodiments, a person of ordinary skill in the art should understand that the technical solution of the present application can be modified or equivalently replaced without departing from the essence and the scope of the technical solution of the present application.

## Claims

1. A cell string formed by spliced N-type IBC solar cells, comprising narrow N-type IBC solar cells and a conducting member configured to realize Ohmic connection between the narrow N-type IBC solar cells, with emitter p+ regions and base n+ regions being alternately arranged on a back surface of each of the narrow N-type IBC solar cells, p+ emitter contact electrodes being arranged in the emitter p+ regions, n+ base contact electrodes being arranged in the base n+ regions, further comprising p+ electrode current convergence points arranged on the p+ emitter contact electrodes and n+ electrode current convergence points arranged on the n+ base contact electrodes, with an insulating barrier layer being arranged around the p+ electrode current convergence points and the n+ electrode current convergence points, and the conducting member being arranged between the adjacent narrow N-type IBC cells.

2. The cell string formed by spliced N-type IBC solar cells according to claim 1, wherein the narrow N-type IBC solar cell comprises an N-type monocrystalline silicon substrate; the N-type monocrystalline silicon substrate has, on its front surface, a n+ doped front surface field and a front surface passivation and anti-inflection film successively from inside out; the N-type monocrystalline silicon substrate has, on its back surface, back surface p+ regions and back surface n+ regions that are alternately arranged successively from inside out, back surface passivation films, and back surface electrodes; and the back surface electrodes comprise p+ emitter contact electrodes and n+ base contact electrodes.

3. The cell string formed by spliced N-type IBC solar cells according to claim 2, wherein the silicon substrate of the narrow N-type IBC solar cell has a resistivity of 1-30 Ω•cm and a thickness of 100-200 µm; the emitter p+ regions and the base n+ regions, which are in a strip shape, are alternately arranged on the back surface of the substrate of the solar cell.

4. The cell string formed by spliced N-type IBC solar cells according to claim 1 or 2, wherein the emitter p+ regions have a width of 500-1500 µm and the base n+ regions have a width of 200-500 µm.

5. The cell string formed by spliced N-type IBC solar cells according to claim 1, wherein both the p+ emitter contact electrodes and the n+ base contact electrodes have a width of 50-150 µm.

6. The cell string formed by spliced N-type IBC solar cells according to claim 1, wherein the p+ electrode current convergence points and the n+ electrode current convergence points are sequentially arranged on the cell in a strip shape; and both the p+ electrode current convergence points and the n+ electrode current convergence points are round points with a diameter of 500 µm, or square points with a length of 500 µm on each side, or metal points in other shapes with an equivalent area.

7. The cell string formed by spliced N-type IBC solar cells according to claim 1 or 6, wherein both the p+ emitter contact electrodes and the n+ base contact electrodes are silver fine grid line electrodes, and both the p+ electrode current convergence points and the n+ electrode current convergence points are silver points.

8. The cell string formed by spliced N-type IBC solar cells according to claim 1, wherein the insulating barrier layer is elongated and has a width of 5 -10 mm and a length of 156 mm; and the insulating barrier layer is covered on arrays of the p+ electrode current convergence points and the n+ electrode current convergence points, respectively, with the p+ electrode current convergence points and the n+ electrode current convergence points exposed from the insulating barrier layer.

9. A method for preparing a cell string formed by spliced N-type IBC solar cells, comprising following steps:
(1) forming, on a back surface of a substrate of a solar cell, emitter p+ regions and base n+ regions that are alternately arranged, preparing p+ emitter contact electrodes in Ohmic contact with the emitter p+ regions and n+ base contact electrodes in Ohmic contact with the base n+ regions, and preparing p+ electrode current convergence points on the p+ emitter contact electrodes and n+ electrode current convergence points on the n+ base contact electrodes;
(2) printing insulating paste onto strips of the p+ electrode current convergence points and the n+ electrode current convergence points by screen printing, with the p+ electrode current convergence points and the n+ electrode current convergence points exposed from the insulating paste, and drying to form an insulating barrier layer;
(3) cutting, along the center of the insulating barrier layer, the substrate of the N-type IBC solar cell into a plurality of narrow N-type IBC cells, wherein the strip of the p+ electrode current convergence points and the strip of the n+ electrode current convergence points are respectively located on the outermost two sides of a long side of the narrow N-type IBC cell, and the cutting is implemented by laser cutting; and
(4) arranging the narrow N-type IBC cells by a certain rule so that the array of the p+ electrode current convergence points of one narrow N-type IBC cell and the array of the n+ electrode current convergence points of the other narrow N-type IBC cell are located between two adjacent narrow N-type IBC cells, coating conducting adhesive onto the p+ electrode current convergence points and the n+ electrode current convergence points, laying a conducting member at a joint of the narrow N-type IBC cells so that the p+ electrode current convergence points and the n+ electrode current convergence points of the adjacent narrow N-type IBC cells are electrically connected by the conducting member, and repeating this step to form a cell string formed by spliced N-type IBC solar cells.

10. The method for preparing a cell string formed by spliced N-type IBC solar cells according to claim 9, wherein
in the step (1), both the p+ electrode current convergence points and the n+ electrode current convergence points are arranged in an array, with 10 to 20 p+ electrode current convergence points or n+ electrode current convergence points in each column, which are uniformly distributed.

11. The method for preparing a cell string formed by spliced N-type IBC solar cells according to claim 9, wherein
in the step (4), the conducting member has a width of 4-8 mm and a thickness of 0.1-0.5 mm, and is made of a tinned copper tape.

12. A solar cell module, comprising a solar cell string, wherein the solar cell string is the cell string formed by spliced N-type IBC solar cells according to any one of claims 1-8.

13. A solar cell system, comprising more than one solar cell module, wherein the solar cell module is the solar cell module according to claim 12.
